# EUROPEAN PATENT APPLICATION

(11) **EP 1 496 731 A1**
(43) Date of publication of application: **12.01.2005**
(21) Application number: 03723104.0
(22) Date of filing: 11.04.2003
(51) Int. Cl.: H05K 3/02

(54) **FAST PRODUCTION METHOD FOR PRINTED BOARD**

(30) Priority: 15.04.2002 JP 2002112287
(71) Applicant: National Institute of Advanced Industrial Science and Technology, Tokyo 100-8921 (JP)
(72) Inventor: Murata, Kazuhiro, Tsukuba-shi (JP)
(74) Representative: Forstmeyer, Dietmar, Dr. rer. nat., Dipl.-Chem.
(86) International application number: PCT/JP2003/004652
(87) International publication number: WO 2003/088726

(57) **Abstract**

A high-speed production method of a printed circuit board comprising the steps of, melting and jet-spraying a solid ink on an insulating substrate to be patterned, leaving portions corresponding to an image part unsprayed, coating a side of the insulating substrate patterned with a conductive layer, and removing solid ink portions by solving, wherein the solid ink comprises a wax as a main component, and wherein the melted solid ink is jet-sprayed for patterning in accordance with data from a computer.

## Description

### TECHNICAL FIELD

The present invention relates to a high-speed production method of a printed circuit board that can perform direct printing in accordance with data from a computer and forming of a resist layer, so that electronic circuit of a printed circuit board or the like can be produced.

### BACKGROUND ART

An electronic circuit, such as a printed circuit board, equipped in an electronic product is having a circuit pattern formed by a conductive material, such as copper, on an insulating substrate. Methods of production such an electronic circuit are roughly classified into two types of subtractive and additive. In the subtractive method, a corrosion-resistant etching resist layer is formed on a conductive layer of a laminated plate obtained by sticking conductive layers on an insulating substrate in advance, and an exposed conductive layer is removed by etching. In the additive method, a corrosion-resistant plating resist layer is formed on an insulating substrate, and a conductive layer is formed on the exposed insulating substrate by a metal-plating process or the like.

As another method, in direct printing, a pattern forming method that a resist of a conductive layer is given, by an inkjet system, on a substrate including at least a conductive layer, is proposed in, e.g., JP-A-2000-340928 ("JP-A" means unexamined published Japanese patent application).

However, since a resist pattern is directly printed on a conductive layer, when the adhesion property is poor between a conductive material and an ink, the resist pattern cannot function as a resist. As a result, a defect may occur on the circuit pattern. A method in which an alkaline soluble resin layer is formed on a conductive layer, is proposed in JP-A-2001-60753 to improve the adhesion property. However, since this method is a positive type, the available line width cannot be made smaller than the dot diameter of an inkjet. Further, the method using a positive resist also has the problem in that the types of conductive metals are limited due to a circuit pattern formed by an etching process.

### DISCLOSURE OF THE INVENTION

The present invention includes a step of jet-spraying a solid ink on an insulating substrate to be patterned, leaving portions corresponding to an image part unsprayed, a step of coating a side of the insulating substrate patterned with a conductive layer, and a step of removing solid ink portions by solving.

Other and further features and advantages of the invention will appear more fully from the following description, taken in connection with the accompanying drawings.

### BRIEF DESCRIPTION OF THE DRAWINGS

FIG. 1 is a side view showing an insulating substrate in a high-speed production method of a printed circuit board according to an embodiment of the present invention.
FIG. 2 is a side view showing a state of a patterned solid ink in a high-speed production method of a printed circuit board according to an embodiment of the present invention.
FIG. 3 is a side view showing a state in which oils or the like are removed by cleaning in a high-speed production method of a printed circuit board according to an embodiment of the present invention.
FIG. 4 is a side view showing a state in which a conductive layer is formed in a high-speed production method of a printed circuit board according to an embodiment of the present invention.
FIG. 5 is a side view showing a state in which solid ink portions are removed by solving in a high-speed production method of a printed circuit board according to an embodiment of the present invention.

### BEST MODE FOR CARRYING OUT THE INVENTION

The present invention will be described below with reference to the accompanying drawings, to explain the present invention in detail.

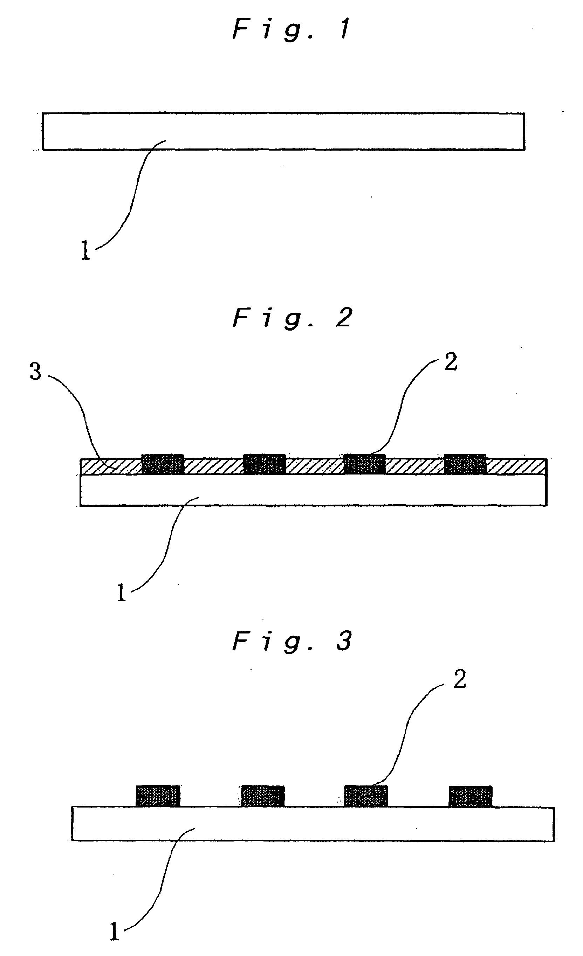

FIGS. 1 to 5 are figures roughly showing an example of a high-speed production method of a printed circuit board according to the present invention.

Firstly, a patterning is directly formed by a solid-ink-jet system that jet-sprays an ink, in such a state that a solid ink 2 at room temperature is thermally melted, on an insulating substrate 1, shown in FIG. 1, leaving portions corresponding to an image part unsprayed, as shown in FIG. 2 (negative pattern formation). In FIG. 2, reference numeral 3 denotes oils (silicon oil or the like) adhered in an offset drum process or the like.

Then, as shown in FIG. 3, the oils 3 or the like on the upper surface of the insulating substrate 1 patterned are removed by ozone cleaning method or the like.

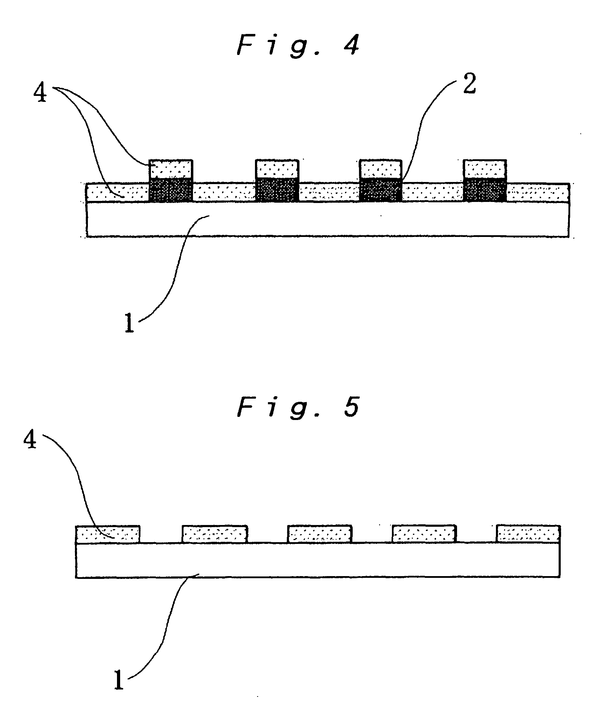

And then, as shown in FIG. 4, the entire surface of the insulating substrate 1 patterned is coated with a conductive layer 4, consisting of a conductive material, such as copper, by means of deposition, electroless plating, coating, or the like.

As shown in FIG. 5, when a resultant structure shown in FIG. 4 is dipped in an organic solvent to solve the solid ink 2, as shown in FIG. 5, the portions patterned by the solid ink 2 are removed by solving, and the conductive layer 4 can be left on the portions corresponding to the image part.

In the direct printing method by the solid-ink-jet system in the present invention, since a negative type is employed, a narrower line can be printed than that obtained by a conventional method of a positive type. A line width can be made smaller depending on improvement in printer accuracy. In an available printer having very high accuracy, for example, a patterning can be made with a line width of 20 µm. Further, since the depositing process or the like of a conductive metal to form a conductive layer is placed afterward, the type of the conductive metal is not limited to print.

In general, the inkjet systems are classified into a charge control system and an electric conversion system (for example, spraying by a piezoelectric element or the like), based on the ink droplet system. The inkjet systems are also classified into a solid ink system and a liquid ink system based on an ink type. In the solid-ink-jet system according to the present invention, an ink, in solid state at room temperature, is thermally melted by thermal energy immediately before printing, to perform recording. Since the system does not use a solvent, it is not necessary to dry it after recording, and high-speed recording can be achieved. Additionally, the ink is not soaked into a recording medium, and recording can be performed on various recording media in high quality.

The solid ink 2 can be used, is in a solid state at room temperature (more specifically, the solid ink is preferably in a solid state at 40°C or less) with appropriate mechanical strength, in contrast to this, with fluidity in a melting state, and with low viscosity required for recording by an inkjet system. Accordingly, the ink requires such characteristics as that it melts sharply at once at a predetermined temperature. As materials having the characteristics, a group of compounds called waxes are known. A solid ink having a melting point in a range from about 50°C to 100°C can preferably be used. The solid ink preferably has surface tension in a range from 25 to 30 mN/m, and viscosity in a range from about 10 to 40 mPa·S, in melting condition. The component of the solid ink, a hydrocarbon-based wax (for example, carnauba wax) or an amide-based wax, is mainly used. The solid ink may contain, such as a dye compound, a pigment, a reactive material such as an ultraviolet curing agent, or the like.

In the present invention, forming of a circuit pattern negative to circuit pattern desired is conducted by jet-spraying a melted solid ink in accordance with data stored in a computer.

A patterned solid ink 2 is removed after a conductive layer is coated. As a means to remove the solid ink, depending on the type of the solid ink, solution processing can be used, in the aforementioned organic solvent, an acid solution, an alkaline solution, or the like.

According to the printed circuit board in the present invention, a circuit pattern of a conductive layer can be formed on one or both sides of an insulating substrate, and it can be finished into a printed wiring board. As the insulating substrate 1 according to the present invention, a glass-based epoxy resin plate, a paper-based phenol resin plate, a paper-based epoxy resin plate, a glass-based polyimide resin plate, a polyester film, a polyimide film, or the like can be used. The thickness of the insulating substrate 1 ranges from several tens of microns to several millimeters. The material and thickness of the insulating substrate 1 can be determined depending on the type of usage of a printed wiring board.

The conductive layer 4 formed on one or both sides of the substrate 1 may consist of a material with a certain conductivity such as a metal and a conductive high polymer. As the metal, copper, silver, aluminum, or the like can be used. The thickness of the conductive layer 4 preferably ranges from several µm to several tens of µm.

In the solid-ink-jet system of the present invention, as a heating means performed by thermal energy to thermally melt an ink in a solid state at room temperature immediately before printing, for example, an on-demand ink heating system can be used. The solid ink has a stick-shape, like a crayon, at room temperature. The stick is liquefied in minimum amount to be held in liquid state, in a non-print state, after the power supply is turned on. In a printing state, a required amount of ink is liquefied by a heater and dropped in an ink-holder. The ink-holder itself is kept at a temperature of about 140°C by a heater, and the ink stays in a liquid state.

### INDUSTRIAL APPLICABILITY

According to the method of the present invention, a melted solid ink is jet-sprayed in accordance with data from a computer, to perform direct printing, so that a resist pattern can be formed. In addition, the resist layer is removed, so that a circuit pattern having a microscopic line width can be formed. Therefore, the method is preferable for a high-speed production of a printed circuit board.

Having described our invention as related to the present embodiments, it is our intention that the invention not be limited by any of the details of the description, unless otherwise specified, but rather be construed broadly within its spirit and scope as set out in the accompanying claims.

## Claims

1. A high-speed production method of a printed circuit board, comprising the steps of:
melting and jet-spraying a solid ink on an insulating substrate to be patterned, leaving portions corresponding to an image part unsprayed;
coating a side of the insulating substrate patterned with a conductive layer; and
removing solid ink portions by solving.

2. The high-speed production method of a printed circuit board according to claim 1, wherein the solid ink comprises a wax as a main component.

3. The high-speed production method of a printed circuit board according to claim 1, wherein the melted solid ink is jet-sprayed for patterning in accordance with data from a computer.
